# EUROPEAN PATENT APPLICATION

(11) **EP 3 971 898 A1**
(43) Date of publication of application: **23.03.2022**
(21) Application number: 21189778.0
(22) Date of filing: 05.08.2021
(51) Int. Cl.: G11C 11/56, G11C 16/10, G11C 16/34, G11C 16/26, G11C 16/04

(54) **FLASH MEMORY HAVING IMPROVED PERFORMANCE AS A CONSEQUENCE OF PROGRAM DIRECTION ALONG A FLASH STORAGE CELL COLUMN**

(30) Priority: 16.09.2020 US 202017023094
(71) Applicant: Intel Corporation, Santa Clara, CA 95054 (US)
(72) Inventor: YANG, Xiang, Santa Clara, 95051 (US); HUANG, Guangyu, El Dorado Hills, 95762 (US); Ramanan, Narayanan, San Jose, 95110 (US); Kalavade, Pranav, San Jose, 95129 (US); Khakifirooz, Ali, Los Altos, 94022 (US)
(74) Representative: Goddar, Heinz J.

(57) **Abstract**

A method is described. The method includes programming a column of flash storage cells in a direction along the column in which a parasitic transistor that resides between a cell being programmed and an immediately next cell to be programmed has lower resistivity as compared to a corresponding parasitic transistor that exists if the programming were to be performed in an opposite direction along the column.

## Description

### Field of Invention

The field of invention pertains to a flash memory having improved performance as a consequence of program direction along a flash storage cell column.

### Background

With the onset of "big-data", cloud-computing, artificial intelligence and other highly data intensive applications, the performance of storage devices is becoming an increasing focus of overall application performance. As such, systems designers and mass storage device designers are becoming increasingly focused on improving the performance of their mass storage devices.

### Figures

A better understanding of the present invention can be obtained from the following detailed description in conjunction with the following drawings, in which:
Fig. 1 depicts a flash memory cell column (prior art);
Figs. 2a and 2b depict flash storage cell charge storage distributions;
Fig. 3 shows a traditional flash memory programming process (prior art);
Fig. 4 shows an improved flash memory programming process;
Fig. 5a, 5b and 5c show a further embodiment of the improved flash memory programming process of Fig. 4;
Fig. 6 shows a corrective read process;
Fig. 7 shows a mass storage device;
Fig. 8 shows a computing system.

### Detailed Description

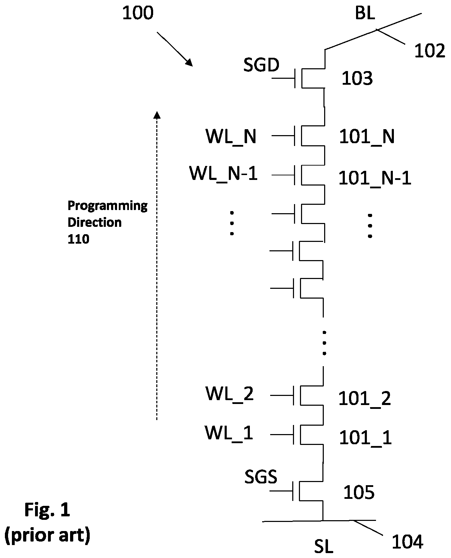

Fig. 1 shows a stack of flash memory cells 100. As observed in Fig. 1, the stack 100 of flash cells includes N transistors 101_1 through 101_N coupled along a vertical column whose respective gate structures correspond to individual storage elements. The column is accessed on the top side via a bit line (BL) 102 and source-gate-drain (SGD) transistor 103. Bias potentials are applied to the column through a bottom side source line (SL) 104 and a source-gate-source (SGS) transistor 105. Here, bottom is understood to mean closer to the semiconductor chip substrate and top is understood to mean farther away from the semiconductor chip substrate.

As is known in the art, flash memory is written to (technically referred to as "programming") in units of blocks. A single block includes an array of flash cell stacks, where, storage cells residing at a same vertical position are tied to a same word line. When reading from or writing to a particular page of information within a block, a particular word line in the block is activated which, in turn, activates the cells of the various stacks that are coupled to that word line. In the case of a read, the respective charges stored in the cells that are coupled to the activated word line influence the potential on their respective columns (technically referred to as "channels") and bit lines which are then sensed to determine the read information (the cells that are not coupled to the activated word line are electrically isolated from their respective columns).

In the case of a write ("program"), the respective bit lines of the stacks are charged consistently with the data to be programmed which, in turn, influences the potential of their respective columns. The cells that are coupled to the activated word line receive charge from their respective column which effectively programs these cells. The voltage placed on the activated word line is referred to as a "program voltage". The cells that are not coupled to the activated word line do not receive the program voltage and are electrically isolated from their columns during the program operation.

Flash cells are programmed according to a "program-verify" process in which, after cells of a same word line are written to with new data using a particular word line voltage, the cells are then read back ("sensed") to confirm that each of their respective stored charge levels is consistent with the data that was intended to be written into them (verify). Those cells that fail (do not store sufficient charge) are then written to again but with a higher program voltage and again re-verified. Cells that pass are isolated from the re-write. The program-verify process then repeats successive iterations of program-verify operations with increasingly higher program voltage with each iteration until all cells that are tied to the activated word line are deemed to pass.

Generally, program operations are applied to an entire block. As such, the above described process is performed for each word line in the block on a word line by word line basis. In a conventional programming approach, the word line by word line programming approach is performed sequentially moving up the column 110.

That is, referring to Fig. 1, cells coupled to the bottom most word line WL1 are first programmed according to the above described process. After the cells coupled to WL1 are fully programmed (all cells are deemed a pass after, e.g., successive program-verify iterations with increasing programming voltage applied to WL1 with each next program iteration), programming of cells coupled to WL2 begins. Cells coupled to WL2 are then programmed according to successive iterations of program-verify operations as described above. After all cells coupled to WL2 are deemed a pass, programming of cells coupled to WL3 begins. The process continues in sequence moving up the column in increasing word line order until cells coupled to the WL_N word line are fully programmed.

Thus, the traditional flash programming sequencing can be characterized as fully programming cells on a word line by word line basis moving up the column 110. As such, cells coupled to a next, immediately higher word line are not programmed until all cells of the current, immediately lower word line being programmed are deemed a "pass" after (typically) successive program-verify operations.

As is known in the art, a single flash cell is capable of storing more that two digital states to effect storage of more than one bit per cell. For example, in the case of quad level cell (QLC), each cell is capable of storing sixteen different charge levels which, in turn, correspond to the storage of four digital bits per cell. In order to successfully store multiple charge levels per cell, the distribution of charge for each separate stored state needs to be fairly tight or precise. If it were otherwise, it would be difficult/impossible to tell which digital state a particular cell is storing.

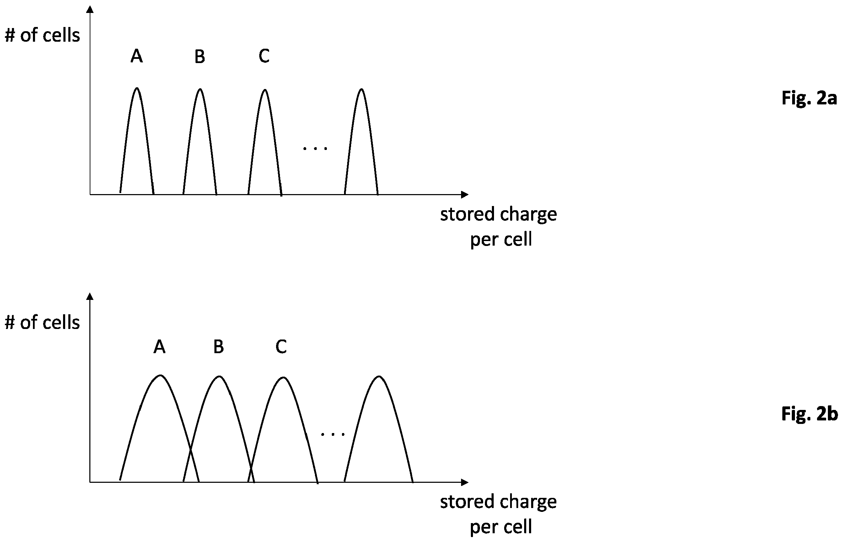

Fig. 2a depicts a representation of desirable stored charge distributions within a particular cell. Here, different stored digital states are depicted with their respective stored charge distributions A, B, C,.... As observed in Fig. 2a, the stored charge distributions for the different states are readily discernable. That is, for example, the stored charge distribution for stored digital state B is isolated and discernable from the stored charge distributions for stored digital states A and C. Because of this isolation, upon a read operation being performed upon any particular cell, it is easy for the read circuitry to determine whether digital state A, B or C has been stored in the particular cell.

Unfortunately, during programming, a first undesirable "disturb effect" can occur which affects a cell's stored charge distributions. Fig. 2b depicts charge distributions that suffer from the aforementioned disturb effect. As observed in Fig. 2b, the respective charge distributions for the A, B and C stored digital states have widened with respect to their counterparts in the preferred distributions of Fig. 2a. As observed in Fig. 2b, charge distributions for neighboring stored digital states overlap with one another, which, in turn, makes it impossible to determine the stored digital state in any cell whose stored charge falls within the regions of overlap.

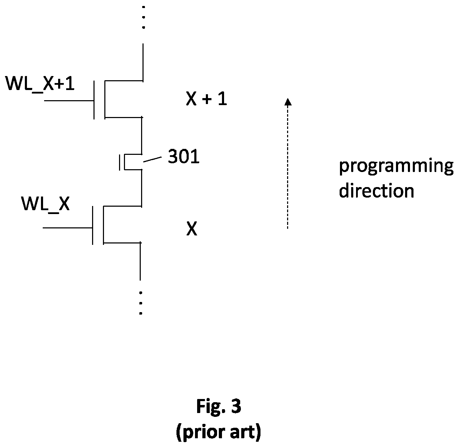

The physics of the disturb problem is described with respect to Fig. 3 and is a result of the "bottom-up" programming order described above with respect to Fig. 1. Fig. 3 shows a circuit model of a portion of the cell stack that includes both the cell being programmed (X) and the cell to be programmed next (X+1). As observed in Fig. 3, because of the bottom-up programming order, the next cell to be programmed X+1 resides above the cell being programmed X along the column. Additionally, a parasitic transistor 301 is observed between the two storage cells. The parasitic transistor 301 results naturally from the construction of the column between the two storage cells. Essentially, a conductive channel is created along the column whose resistivity can be modulated by the voltages that are applied to the column and its respective cells during the program-verification process.

As described above, during the program verification process, the word line of the cell being programmed WL_X is first programmed with a program voltage and then the cell is sensed to see if a correct charge amount has been stored in the cell. During the sense operation, current flows through the column in inverse proportion to the amount of charge stored in the programmed cell (the greater the stored charge the less the current that flows through the column), and, in inverse proportion to the resistivity of the parasitic transistor 301 (the greater the resistivity of the parasitic transistor 301, the less current flows through the column). Unfortunately, the application of a positive bit line voltage (e.g. 1.0 V) during the sense elevates the voltage along the column above the cell being programmed, which, in turn, increases the resistivity of the parasitic transistor 301.

The increase in the resistivity of the parasitic transistor 301 results in less sense current during verification which, in turn, is interpreted as greater charge being stored in the cell being programmed X than has actually been stored. That is, the sensing control circuitry believes greater charge has been stored in the cell X than what has actually been stored in the cell. This, in turn, corresponds to increased cell charge distributions. That is, cells are regularly programmed with their particular stored state level, which, in turn are interpreted such that the stored charge of at least some of these cells to overlap into the next stored state level.

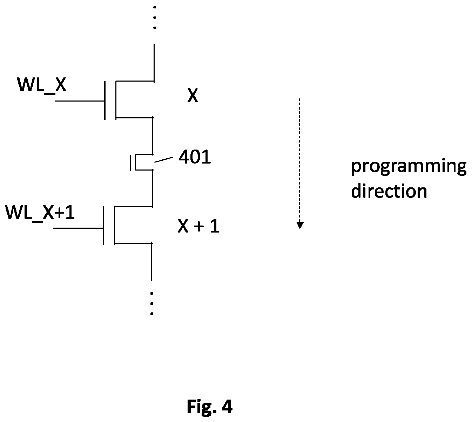

The effect of the parasitic transistor 401 can be greatly diminished, as observed in Fig. 4, by programming in a "top-down" rather than "bottom-up" direction. Here, both the next cell to be programmed X+1 and the parasitic transistor 401 are observed to be beneath the cell being programmed X. Importantly, during the sense operation of the cell's program-verify sequence, a reference voltage (e.g. 0.0 v, which is less than bitline voltage) is applied to the source line at the bottom of the column rather than an affirmative bias.

As a consequence, the voltage along the column beneath the cell being programmed X is much lower in the top-down approach of Fig. 4 (e.g., 0.0 v) than the voltage along the column above the cell being programmed in the bottom-up approach of Fig. 3 (e.g., 1.0v). The lower column voltage results in the parasitic transistor 401 of the top-down approach of Fig. 4 having less resistivity than the parasitic transistor 301 of the bottom-up approach of Fig. 3. As such, the efficiency of the sense operation during verification is greatly improved which, in turn, prevents programming the cells with too much charge. With the cells being programmed with the correct amount of charge rather than too much charge, the aforementioned excessive spread of charge distribution for any particular stored state does not occur.

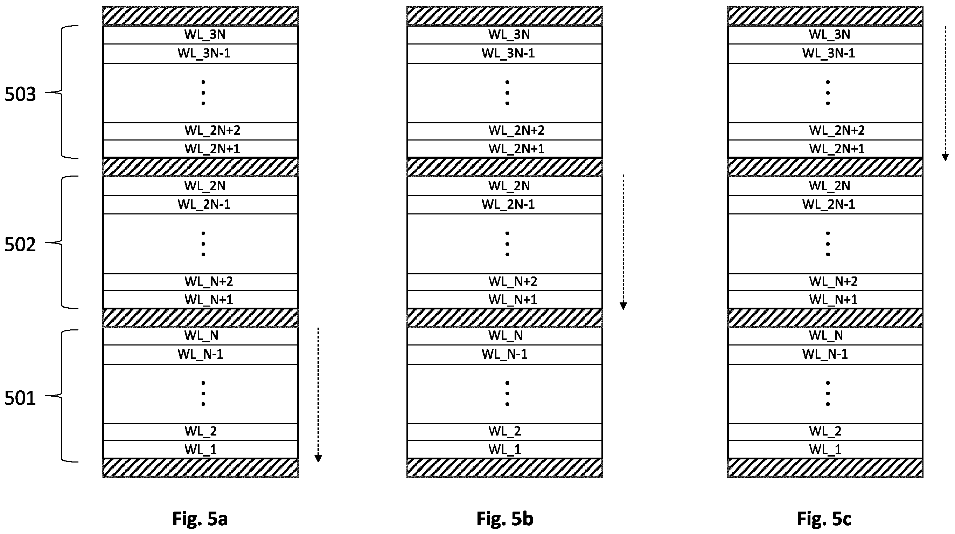

Figs. 5a, 5b and 5c depict a cross section of flash memory column having more than one blocks worth of storage cells per column. As observed in Fig. 5a, cell stacks for three different blocks 501, 502, 503 are observed along the column. Here, any of the three blocks 501, 502, 503 can be individually accessed for programming purposes. As such, the "top-to-bottom" approach only extends to those cells associated with a same block along the column. For example, as depicted in Fig. 5a, if block 501 is to be programmed, the programming sequence starts at cell N, progressively moves down the column, and then ends at cell 1. Likewise, as observed in Fig. 5b, if block 502 is to be programmed, the programming sequence starts at cell 2N, moves progressively down the column and then ends at cell N+1. Finally, as observed in Fig. 5c, if block 503 is to be programmed, the programming sequence starts at cell 3N, moves progressively down the column and then ends at cell 2N+1.

Before any of these blocks 501, 502, 503 are programmed, the cells of the block are erased before the programming sequence begins. That is, for example, referring to Fig. 5a, the cells of block 501 are erased before they are programmed. After the cells are programmed, their contents are free to be read as actual read data.

The read of the actual data, however, needs to take account of another disturb effect that might have happened during the programming of the cells, and, which is different than the disturb effect described above with respect to Figs. 3 and 4 that pertain to the parasitic transistor 301, 401. In particular, recall that the disturb effect described above with respect to Figs. 3 and 4 occurs before the programming of the next cell to be programmed X+1. By contrast, the disturb effect that the actual read process needs to take account of occurs during the programming of the next cell X+1.

Here, referring briefly back to Fig. 4, after cell X has been fully programmed (its program-verify sequences are completed), and cell X+1 is undergoing its program-verify sequence, the programming of cell X+1 can disturb the charge stored in cell X. In particular, during the programming of cell X+1, cell X appears to "gain" some charge as a result of the more resistive parasitic transistor. Thus, after cell X+1 has been programmed, cell X can have more charge than what it was programmed to contain. In particular, if cell X+1 is programmed with a threshold amount of charge, enough resistance can be added to cell X to warrant an adjustment to cell X's read process.

A corrective read algorithm is therefore designed to adjust the voltages used during an actual read of cell X based on the stored charge content of cell X+1. Here, still referring to Fig. 4, because programming is performed in a top-down direction, cell X+1 is beneath cell X.

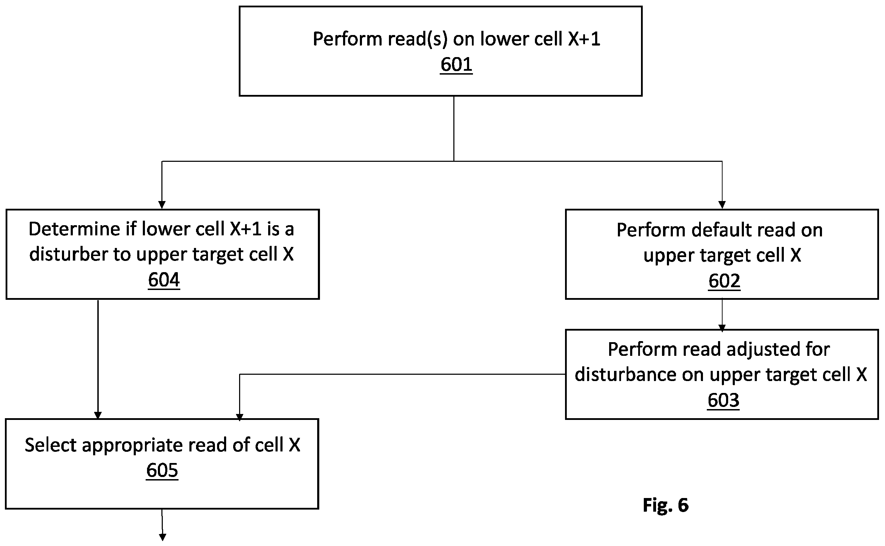

Referring to the corrective read algorithm of Fig. 6, in order to read cell X, initially, one or more reads are performed 601 on lower cell X+1 to determine if cell X+1 stores a threshold amount of charge sufficient to disturb cell X during the programming of cell X+1. Cell X is then read twice 602, 603 with two different word line voltages. The word line voltage used for one of the reads 602 is a default word line voltage that is appropriate if there is little/no possibility that cell X was disturbed by the programming of cell X+1. By contrast, the word line voltage used for the other of the reads 603 is an adjusted word line voltage (having some offset from the default word line voltage) that compensates for a presumed disturbance of cell X that resulted from the programming of cell X+1.

One of the reads 602, 603 is then selected 604 as the actual read of cell X based on whether or not lower cell X+1 is deemed 605 to have a threshold amount of charge sufficient to disturb the charge stored in cell X.

Here, the read(s) 601 of cell X+1 may encompass multiple reads, e.g., to "zero-in" on whether cell X+1 stores the requisite threshold amount of charge to be deemed a disturber of cell X. That is, for example, if the possible stored charge levels of cell X+1 can range from Y to Y+Z, a first read may be performed on cell X+1 to see if its stored charge level is at least Y+(Z/2), then, a second read may be performed on cell X+1 to see if its stored charge level is at least Y+(3Z/4), then, a third read may be performed on cell X+1 to see if its stored charge level is at least Y+(7Z/8).

Here, for example, cell X+1 will be deemed to have disturbed cell X only if the third read determines that cell X+1 stores a charge level of at least Y+(7Z/8). Note that the second or third reads of cell X+1 need not be performed if an earlier read determines that cell X+1 does not contain the tested for amount of charge (e.g., the second read is not performed if the first read determines that cell X+1 does not contain a charge level of at least Y+(Z/2)).

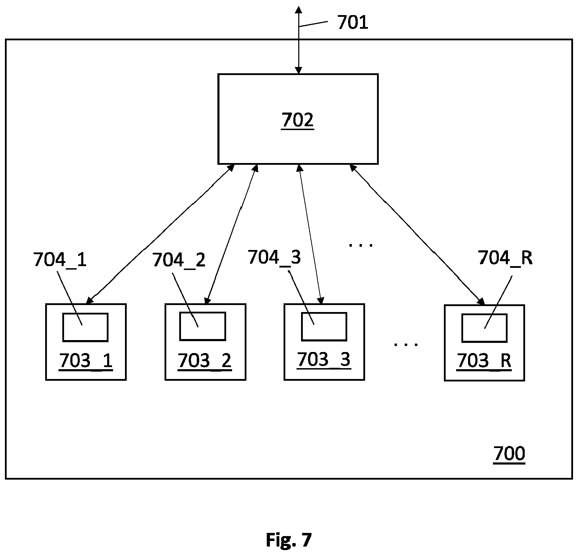

Fig. 7 depicts a mass storage device 700, such as a solid state drive (SSD), that is composed of a controller 702 and multiple flash memory chips 703_1 through 703_R. The controller 702 controls the mass storage device 700 and interfaces with a host through interface 701. The controller receives read and write requests from the host through the interface and applies them to at least one of the flash memory chips as appropriate. The flash memory chips 703_1 through 703_R include respective circuitry 704_1 through 704_R to apply appropriate electronic signal waveforms and/or voltages to the columns of their respective chips. Such circuitry 704 can be designed to implement the teachings described above in Figs. 2b and 4 through 6.

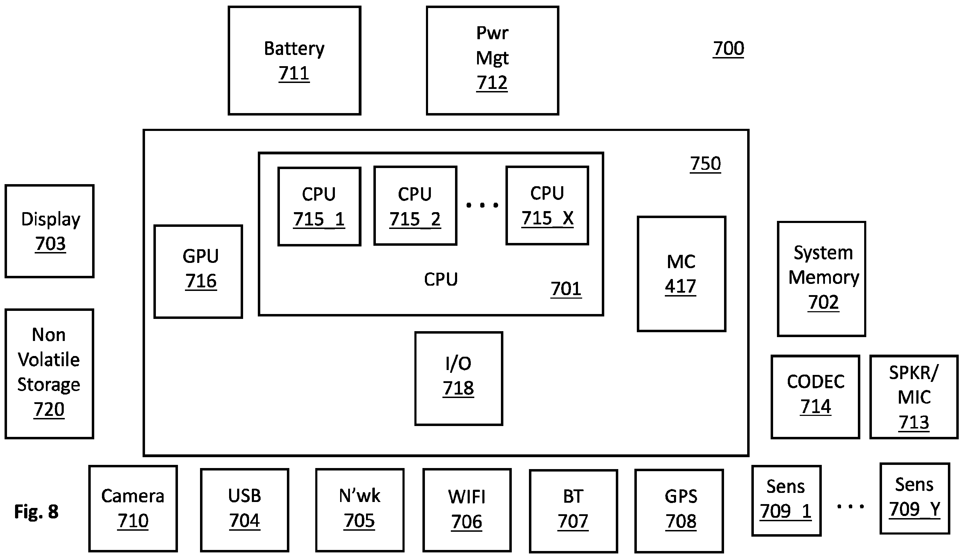

FIG. 8 provides an exemplary depiction of a computing system 800. Any of the aforementioned cloud services can be constructed, e.g., from networked clusters of computers having at least some of the components described below and/or networked clusters of such components.

As observed in FIG. 8, the basic computing system 800 may include a central processing unit (CPU) 801 (which may include, e.g., a plurality of general purpose processing cores 815_1 through 815_X) and a main memory controller 817 disposed on a multi-core processor or applications processor, main memory 802 (also referred to as "system memory"), a display 803 (e.g., touchscreen, flat-panel), a local wired point-to-point link (e.g., universal serial bus (USB)) interface 804, a peripheral control hub (PCH) 818; various network I/O functions 805 (such as an Ethernet interface and/or cellular modem subsystem), a wireless local area network (e.g., WiFi) interface 806, a wireless point-to-point link (e.g., Bluetooth) interface 807 and a Global Positioning System interface 808, various sensors 809_1 through 809_Y, one or more cameras 810, a battery 811, a power management control unit 812, a speaker and microphone 813 and an audio coder/decoder 814.

An applications processor or multi-core processor 850 may include one or more general purpose processing cores 815 within its CPU 801, one or more graphical processing units 816, a main memory controller 817 and a peripheral control hub (PCH) 818 (also referred to as I/O controller and the like). The general purpose processing cores 815 typically execute the operating system and application software of the computing system. The graphics processing unit 816 typically executes graphics intensive functions to, e.g., generate graphics information that is presented on the display 803. The main memory controller 817 interfaces with the main memory 802 to write/read data to/from main memory 802. The power management control unit 812 generally controls the power consumption of the system 800. The peripheral control hub 818 manages communications between the computer's processors and memory and the I/O (peripheral) devices.

Each of the touchscreen display 803, the communication interfaces 804 - 807, the GPS interface 808, the sensors 809, the camera(s) 810, and the speaker/microphone codec 813, 814 all can be viewed as various forms of I/O (input and/or output) relative to the overall computing system including, where appropriate, an integrated peripheral device as well (e.g., the one or more cameras 810). Depending on implementation, various ones of these I/O components may be integrated on the applications processor/multi-core processor 850 or may be located off the die or outside the package of the applications processor/multi-core processor 850. The computing system also includes non-volatile mass storage 820 which may be the mass storage component of the system which may be composed of one or more non-volatile mass storage devices (e.g. hard disk drive, solid state drive, etc.). The non-volatile mass storage 820 may be implemented with any of solid state drives (SSDs), hard disk drive (HDDs), etc. To the extent the mass storage includes SSDs, or other types of semiconductor based storage, the SSDs/storage can be composed of a flash memory chip having characteristics as described at length above with respect to Figs. 2b and 4 through 6.

Embodiments of the invention may include various processes as set forth above. The processes may be embodied in program code (e.g., machine-executable instructions). The program code, when processed, causes a general-purpose or special-purpose processor to perform the program code's processes. Alternatively, these processes may be performed by specific/custom hardware components that contain hard interconnected logic circuitry (e.g., application specific integrated circuit (ASIC) logic circuitry) or programmable logic circuitry (e.g., field programmable gate array (FPGA) logic circuitry, programmable logic device (PLD) logic circuitry) for performing the processes, or by any combination of program code and logic circuitry.

Elements of the present invention may also be provided as a machine-readable medium for storing the program code. The machine-readable medium can include, but is not limited to, floppy diskettes, optical disks, CD-ROMs, and magneto-optical disks, FLASH memory, ROMs, RAMs, EPROMs, EEPROMs, magnetic or optical cards or other type of media/machine-readable medium suitable for storing electronic instructions.

In the foregoing specification, the invention has been described with reference to specific exemplary embodiments thereof. It will, however, be evident that various modifications and changes may be made thereto without departing from the broader spirit and scope of the invention as set forth in the appended claims. The specification and drawings are, accordingly, to be regarded in an illustrative rather than a restrictive sense.

## Claims

1. A method, comprising:
programming a column of flash storage cells in a direction along the column in which a parasitic transistor (401) that resides between a cell being programmed and an immediately next cell to be programmed has lower resistivity as compared to a corresponding parasitic transistor that exists if the programming were to be performed in an opposite direction along the column.

2. The method of claim 1 wherein the direction is towards a semiconductor substrate (104) of the flash memory chip that the column is integrated upon.

3. The method of claim 1 wherein the direction is towards a source-gate-source transistor (105) that exists at an end of the column.

4. The method of claim 3 wherein the direction is away from a bit line (102) that is coupled to an opposite end of the column.

5. The method of claim 1 wherein the direction is away from a bit line (102) that is coupled to an end of the column.

6. The method of claim 1 wherein the method further comprises reading the cell after the column of flash cells has been fully programmed, the reading comprising:
reading the immediately next cell;
performing a first read of the cell, the first read of the cell being a default read of the next cell;
performing a second read of the cell, the second read accommodating for a the cell having been disturbed by programming of the immediately next cell;
determining, based on the reading of the immediately next cell, if the immediately next cell's stored charge is sufficient to have disturbed the cell during programming of the immediately next cell;
based on the determining, selecting one of the first and second reads as the cell's read.

7. An apparatus, comprising:
a flash memory chip comprising circuitry (704) to program a column of flash storage cells in a direction along the column in which a parasitic transistor (401) that resides between a cell being programmed and an immediately next cell to be programmed has lower resistivity as compared to a corresponding parasitic transistor that exists if the programming were to be performed in an opposite direction along the column.

8. The apparatus of claim 7 wherein the direction is towards a semiconductor substrate (104) of the flash memory chip that the column is integrated upon.

9. The apparatus of claim 7 wherein the direction is towards a source-gate-source transistor (105) that exists at an end of the column.

10. The apparatus of claim 9 wherein the direction is away from a bit line (102) that is coupled to an opposite end of the column.

11. The apparatus of claim 7 wherein the direction is away from a bit line (102) that is coupled to an end of the column.

12. The apparatus of claim 7 wherein the circuitry is to read the cell after the column of flash cells has been fully programmed, the circuitry to further in performance of the read:
read the immediately next cell;
perform a first read of the cell, the first read of the cell being a default read of the next cell;
perform a second read of the cell, the second read accommodating for a the cell having been disturbed by programming of the immediately next cell;
determine, based on the read of the immediately next cell, if the immediately next cell's stored charge is sufficient to have disturbed the cell during programming of the immediately next cell;
based on the determination, select one of the first and second reads as the cell's read.

13. A computing system comprising the subject matter of any of claims 7 through 12.

14. An apparatus, comprising:
means for programming a column of flash storage cells in a direction along the column in which a parasitic transistor that resides between a cell being programmed and an immediately next cell to be programmed has lower resistivity as compared to a corresponding parasitic transistor that exists if the programming were to be performed in an opposite direction along the column.
